Europäisches Patentamt

(19) European Patent Office

Office européen des brevets

(11) Publication number: **0 021 402**
**B1**

# (12) EUROPEAN PATENT SPECIFICATION

(45) Date of publication of patent specification: **09.10.85**

(21) Application number: **80103554.4**

(22) Date of filing: **24.06.80**

(51) Int. Cl.⁴: **H 01 L 23/54,** H 01 L 23/14, H 05 K 1/00

(54) Integrated circuit board.

(30) Priority: **29.06.79 US 53497**

(43) Date of publication of application:
**07.01.81 Bulletin 81/01**

(45) Publication of the grant of the patent:
**09.10.85 Bulletin 85/41**

(84) Designated Contracting States:
**BE DE FR GB IT SE**

(56) References cited:
**US-A-3 299 393**
**US-A-3 351 816**
**US-A-3 519 959**
**US-A-4 047 132**

**IBM Journal of Research & Development, May
1969, pages 226-238**

(73) Proprietor: **International Business Machines
Corporation
Old Orchard Road
Armonk, N.Y. 10504 (US)**

(72) Inventor: **Miersch, Ekkehard F.
NarzissenStrasse
D-7030 Böblingen 4 (DE)**
Inventor: **Romankiw, Lubomyr T.
7 Dunn Lane
Briarcliff Manor New York 10510 (US)**

(74) Representative: **Ahlman, Bertel
IBM Svenska AB Box 962
S-18 109 Lidingö (SE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention relates to an integrated circuit board for packaging large scale integration chips.

A salient objective in packaging circuits for future high speed computers is to inhibit electrical noise from simultaneous switching of a large number of circuits. This noise arises from the non-zero inductance, L, of the power supply network and is proportional to $L\triangle I/\triangle t$, where $\triangle I$ is the total switched current with a rise time $\triangle t$.

This noise is typically controlled in part by minimizing power supply inductance and in part by using decoupling capacitors which smooth out the associated voltage transients in the power supply networks. Future performance requirements suggest the need to provide "integrated capacitors" (minimum self and lead inductance) physically placed as closely as possible to the semi-conductor chips.

U.S. patent 3,519,959 describes a power distribution substrate with a number of parallel planar conductors for providing integral conductors and capacitors in a unit which is adapted to connect to a component board to which a number of electrical components are secured. The component board has an edge including a plurality of aligned pins which connect to a number of openings in the power distribution substrate where the planar conductors can contact the pins.

The invention here disclosed aims at improving the A.C. characteristic of laminated packaging boards for LSI chips by minimizing inductance of and integrating increased decoupling capacitance into the boards.

The board as claimed includes stacked planar metallic sheets acting as power planes having large parallel surfaces with high electrical capacitance and minimal inductive coupling therebetween. Areas of the surface of the board on which LSI chips are mounted are connected to the power sheets by integrated coaxial conductive extensions from the sheets having a high degree of capacitance coupling to adjacent conductive sheets and low inductance.

The invention differs from the background art cited especially in the links for connecting the conductive sheets to the laminated board surface and in the connection terminals. The advantages offered are mainly that the LSI chips are secured directly to the board, that is, as closely as possible to the integrated capacitors and that the preformed metal sheets do not require any drilling or other piercing operation during or after assembly.

In the accompanying drawings:

FIG. 1 is a sectional perspective view of a laminated packaging structure or board in accordance with the invention.

FIG. 2 is a similar view of FIG. 1 wherein an additional lamination layer is added.

FIG. 3 is a sectional perspective view of a pair of boards in spaced superposition with circuit components connected to the lower board, the upper board being a fragment only.

FIG. 4A is a plan view of an upper conductive element of a board in accordance with the invention.

FIG. 4B is a sectional view taken along line 4B—4B in FIG. 4A.

FIG. 4C is a bottom view of the conductive element of FIG. 4A.

FIG. 5A shows a plan view of a mating lower conductive element adapted for accepting the element of FIGS. 4A—C to be inserted thereinto.

FIG. 5B is a sectional view taken along line 5B—5B in FIG. 5A.

FIG. 5C is a bottom view of the conductive element shown in FIG. 5A.

FIG. 6 is a perspective view of the elements of FIGS. 4C and 5A prior to assembly.

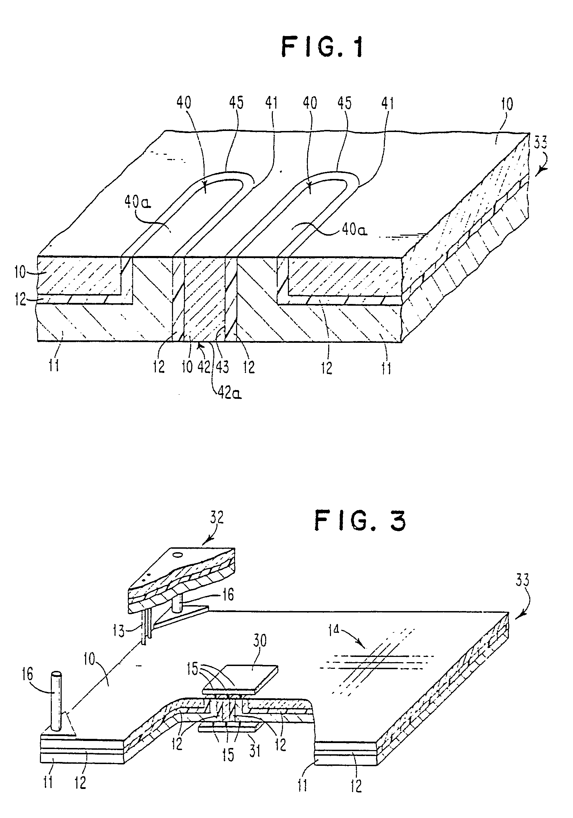

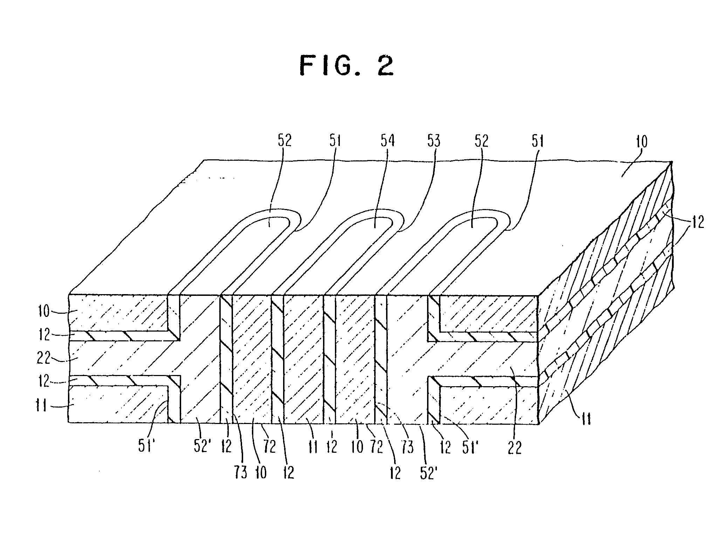

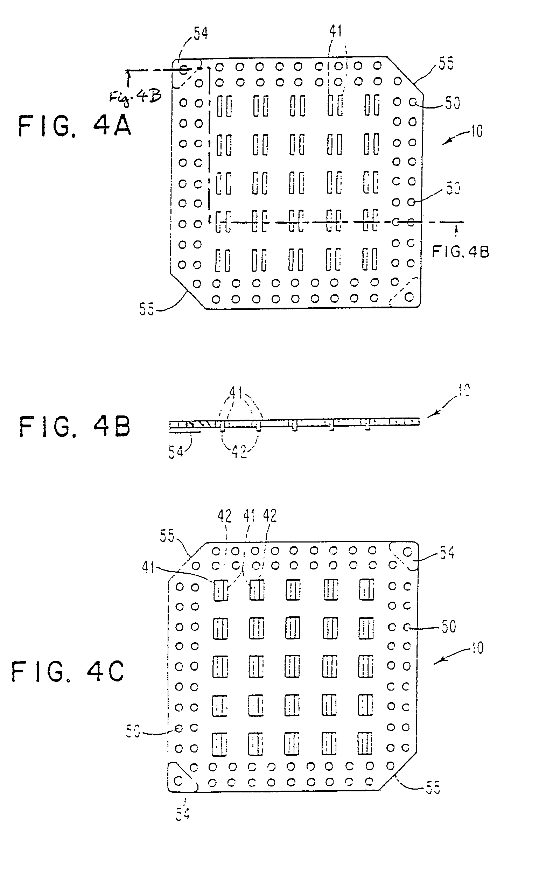

The packaging structure or board shown in FIGS. 1 and 2 consists of two or three generally parallel conductive sheets 10 and 11 (FIG. 1) or 10, 22 and 11 (FIG. 2) separated by dielectric layers 12. Conductive sheets 10 and 11 or 10, 22 and 11 serve as power supply planes for conducting and connecting electrical power to LSI chips, for example chip 30 in FIG. 3.

In FIG. 1, the lower sheet 11 of a two conductive sheet board 33 has pads 40 extending up through sheet 10 in openings 41 in sheet 10 so as to form land areas 40a on the upper surface of the board 33. Similarly, an opening 43 is provided through sheet 11 so that pad 42 can extend through to the lower surface of sheet 11 from upper sheet 10 forming a land area 42a similar to land areas 40a. In this way, connection to the upper sheet 10 from below the board 33 is provided, as well as connection to the lower sheet (11) from above the board 33. As shown, pads 40 comprise generally rectangular shapes in openings 41 in the upper surface of sheet 10, with rounded ends 45. Similarly, pad 42 comprises a generally rectangular shape in opening 43 in the lower surface of sheet 11, with rounded ends (not shown).

In FIG. 2, a three conductive sheet board is shown. The upper sheet 10 rests above intermediate sheet 22, which in turn rests upon lower sheet 11. Separating the conductive sheets 10, 22, 11 in the same way as in FIG. 1 are the layers 12 of dielectric material. The intermediate sheet 22 has pads 52 extending up through sheet 10 in openings 51 in sheet 10 and pads 52' extending down through lower sheet 11 in openings 51' through sheet 11. In addition, lower sheet 11 has a pad 54 extending up through opening 53 through sheets 22 and 10 to the upper surface of sheet 10. Similarly, openings 73 are provided through sheets 22 and 11 so that pads 71 can extend through to the lower surface of sheet 11 from upper sheet 10. In this way, land areas above the board are connected to the lower sheet 11 and the intermediate sheet 22 and vice versa, land areas below the board are connected to the upper sheet 10 and the intermediate sheet 22.

In FIG. 3 a pair of two sheet boards 32, 33 arranged in spaced superposition are shown. The lower board 33 carries solder pad-mounted flip-chips, chip 30 being an example of a large array of chips. Upon conductive sheet 10 of the board 33 a multimetal layer thin film structure provides a grid 14 of orthogonal interconnection wires. They are insulated from sheet 10 and where necessary are connected to the power sheets 10, 11 of the board 33 by vias which are not shown. Connection to other devices, such as chip 30, is made over solder pads 15 (See P. A. Totta, R. P. Sopher, "SLM Device Metallurgy and Its Monolithic Extension", IBM Journal of Research and Development, May 1969, pp. 226—238). Connection between two different boards 32 and 33 or to the next packaging level can be performed by pins 13 and/ or edge connectors, press contacts or soldering. Power is supplied over power rods 16, cables or thicker pins. Besides chip 30 a bonded decoupling capacitor 31 is shown. A fragment only of the next board 32 is shown above lower board 33, supported on rod 16.

FIGS. 4A, 4B and 4C show different views of the upper conductive element 10 of a two conductive sheet board. Upper element 10 comprises the upper conductive sheet of board 33 of FIG. 1 with pads 42 and openings 41. In addition, near the periphery of the upper element 10 is located an array of apertures 50 for vias. The vias would comprise wires having substantially smaller diameters than the apertures 50. Projections 54 are provided on two diagonally opposed corners of element 10 and alignment edges 55 are provided on the other two corners of element 10.

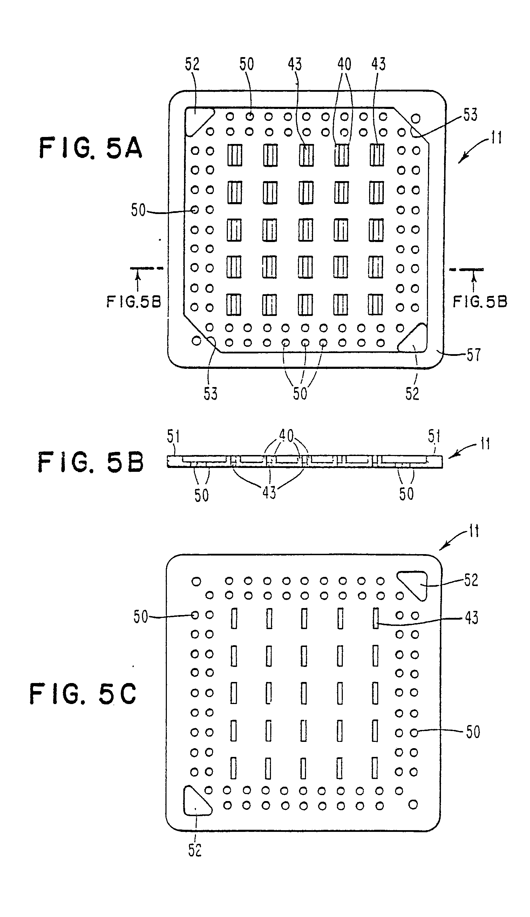

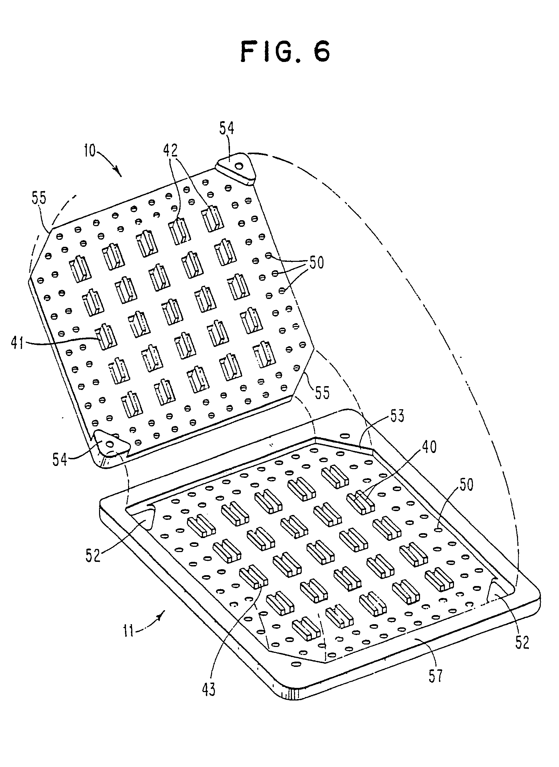

FIGS. 5A, 5B and 5C show different views of the lower conductive element 11 of the two conductive sheet board. Lower element 11 comprises the lower conductive sheet 11 of board 33 of FIG. 1 with pads 40 and openings 43 for accepting pads 42 provided in upper element 10 in FIGS. 4C and 6. In addition, as in the upper element 10, near the periphery of the lower element 11 is located an array of apertures 50 for vias. An alignment flange 57 is also provided about the edge of the lower element 11 for holding the upper element 10. Alignment holes 52 are provided in diagonally opposite corners of the lower element 11 for reception of projections 54 on the upper element 10. On the other diagonally opposed corners of the inner margin of flange 57 alignment edges 53 are provided for holding or aligning edges 55 of the upper element 10.

FIG. 6 shows the elements of FIGS. 4 and 5 prior to assembly. When FIG. 4C is superposed upon FIG. 5A as indicated, the upper element 10 is inserted into the area surrounded by flange 57 of lower element 11 and the clearances are selected to be sufficient that the application of dielectric 12 prior to assembly of elements 10 and 11 together will afford uniform dielectric thickness and insulation of the elements 10 and 11 from one another. After assembly each of pads 42 in the upper element 10 is inserted into an opening 43 in lower element 11 between two pads 40. Conversely, each pair of pads 40 in the lower element 11 are inserted into two corresponding openings 41 in the upper element 10 so as to embrace a pad 42. As illustrated in FIG. 1, but not shown in FIGS. 4, 5 and 6, for convenience of machining during manufacture pads 40 and 42 have preferably rounded ends 45.

As regards material requirements, conductive sheets 10 and 11 of the board can be made of any highly conductive metal or alloy, which is desirable from the point of view of cost and fabrication. Metal formed by injection molding is most desirable. Suitable metals are aluminum or its alloys, beryllium or its alloys, copper or its alloys, and molybdenum or its alloys. Considering solder pad techniques and the expansion coefficient of $2.6 \times 10^{-6}/°C$ of silicon, molybdenum has a coefficient of $2.7 \times 10^{-6}/°C$ which is the closest expansion coefficient to silicon, and therefore is a preferred metal.

Dielectric 12 between conductive sheets 10 and 11 of the board separates the sheets (power planes) electrically, and connects them mechanically. Dielectric 12 must have good adhesion to the metal or its oxide. Dielectric 12 also must tolerate solder temperatures. Dielectrics, such as, polyimide, polysulfone, polycarbonate or any other high temperature polymers provide such characteristics. Inorganic materials such as some glasses and ceramics are satisfactory. Several refractory metals can be covered by native oxides which adhere well. In general, adhesion of polymers to oxides is good. In those cases, an excellent bond occurs automatically. With aluminum and beryllium, metal oxides are used to insulate thin film lines 14 on top of the board for use in integrated circuit techniques. These oxides can be produced either by anodization or by other deposition methods.

In case of aluminum sheets the process steps to achieve the board structure are as follows: Single metal sheets, manufactured by machining or injection molding are coated with oxide by anodization. The dimensional tolerances for the sheets take into account anticipated growth or shrinkage of each individual metal sheet from anodization. Aluminum sheets 10 and 11 are insulated from each other for direct current by polymer 12 as well as the aluminum anodized to $Al_2O_3$. The relatively high dielectric constant of $Al_2O_3$ between conductive sheets 10 and 11 is favorable, because it increases the AC-coupling therebetween so that they act at the same time as a decoupling capacitor. In further processing steps if necessary, the board surface is planarized by lapping so the surface topography meets the flatness requirements of following thin film interconnection layers 14.

The board structure can include Al metallurgy and $Al_2O_3$ as insulators as follows; After the board surface is planarized, an aluminum layer of about 50 µm is deposited on top of a 20 nm thick layer of Nb (Ta, Hf, Ti, Si, etc.). At this point studs are formed by selectively anodizing the Al in all areas except at contacts. The niobium (Ta, Hf, Ti, etc.) under $Al_2O_3$ is converted to niobium (Ta, Hf, Ti, etc.) oxide in a subsequent oxidation step. From a point of view of contact resistance it may be desirable to omit Nb (Ta, Hf, Ti, etc.) from the contacts areas. In such a case a masking step can be used to remove Nb (Ta, Hf, Ti, etc.) from the contact prior to Al deposition.

Subsequent interconnection layers are built up by depositing an additional pair of Nb (Ta, Hf, Ti, etc.) and aluminum layers. This is followed by appropriate masking steps and selective anodizing to define the wiring pattern of the first layer of interconnection wires 14. As in the previous step, the niobium has to be converted to Nb (Ta, Hf, Ti) oxide.

Both the stud (or via) layers and conductor metallurgy layers are formed in the same manner except that the stud layers use different masks from the conductor layers. Thus, the Nb (Ta, Hf, Ti, etc.) and Al deposition, masking, anodization and heating steps are repeated as many times as is necessary to build up the desired number of interconnection layers 14.

Alternatively the required number of interconnection wire layers 14 can be achieved through the use of polyimide and copper, polyimide and gold, Parylene (a trademark of Union Carbide Corporation) polyparaxylene film and copper and Parylene film and gold. The combination of a molybdenum board with polyimide as an insulator, and copper thin film wires in Parylene film (relative) dielectric constant of 3) as an insulator is a most promising high speed board approach. Both copper and gold would be electroplated or deposited by electroless means.

## Claims

1. Integrated circuit board (33) comprising at least two conductive sheets (10, 11) separated by a dielectric layer (12), characterized in that said sheets (10, 11) are comprised of mating preformed metal sheets with at least one pad (42) on one sheet (10) cooperating with one opening (43) in the other sheet (11), said pad (42) providing upon said other sheet (11) a chip connection terminal in the form of a conductive land area (42a) insulated by said dielectric layer (12) form said other sheet (11).

2. A board (33) as claimed in claim 1, with at least one pair of pads (40) on said other sheet (11) cooperating with one pair of openings (41) in said one sheet (10), said pair of pads (40) providing upon said one sheet (10) chip connection terminals in the form of land areas (40a) insulated by said dielectric layer (12) from said one sheet (10), the two pads (40) in said pair of pads being separated by said one pad (42) fitting therebetween, said layer (12) providing uniform dielectric thickness between said sheets (10, 11) including said pads (40, 42) and said openings (41, 43).

3. A board (33) as claimed in claim 1, wherein said sheets (10, 11) are power supply planes, said board (33) having a multimetal layer thin film wiring pattern (14) deposited thereon for connection to signal lines of a plurality of chips (30).

4. A board (33) as claimed in claim 1, with a plurality of chips (30) directly mounted thereon by solder pads (15).

## Revendications

1. Plaquette (33) pour circuits intégrés, comportant au moins deux plaques conductrices (10, 11) séparées par une couche (12) de diélectrique, caractérisée en ce que les plaques (10, 11) sont constituées de plaques métalliques préformées qui s'accouplent, au moins une patte (42) sur une plaque (10) coopérant avec une ouverture (43) de l'autre plaque (11), la patte (42) réalisant sur l'autre plaque (11) une borne de liaison pour puce sous forme de surface conductrice (42a) isolée de l'autre plaque (11) par la couche (12) de diélectrique.

2. Plaquette (33) selon la revendication 1, avec au moins deux pattes (40) sur l'autre plaque (11) coopérant avec deux ouvertures (41) de la plaque (10), les deux pattes (40) réalisant sur la plaque (10) des bornes de liaison pour puces sous forme de surfaces (40a) isolées de la plaque (10) par la couche (12) de diélectrique, les deux pattes (40) précitées étant séparées par une patte (42) s'ajustant entre elles, la couche (12) présentant une épaisseur de diélectrique uniforme entre les plaques (10, 11) qui comporte les pattes (40, 42) et les ouvertures (41, 43).

3. Plaquette (33) selon la revendication 1, dans laquelle les plaques (10, 11) sont des plans d'alimentation électrique, un réseau (14) de fils à couche mince en couche polymétallique étant déposé sur la plaquette (33) en vue de leur liaison avec les lignes d'acheminement de signaux d'une série de puces.

4. Plaquette (33) selon la revendication 1, sur laquelle une série de puces (30) sont montées directement au moyen de pattes de soudure (15).

## Patentansprüche

1. Integrierte Schaltungsplatte (33) mit mindestens zwei durch eine dielektrische Schicht (12) getrennten Leitenden Folien (10, 11), dadurch gekennzeichnet, dass diese Folien (10, 11) durch zusammengesetzte vorgeformte Metallfolien unter Zusammenwirken von mindestens einem Füllstück (42) an der einen Folie (10) mit einer Oeffnung (43) in der anderen Folie (11) gebildet werden, wobei durch dieses Füllstück (42) auf der besagten anderen Folie (11) ein Chipverbindungsanschluss in Form einer leitenden, von diesen anderen Folie (11) durch die besagte dielektrisch Schicht (12) isolierten Anschlussfläche (42a) vorgesehen wird.

2. Platte (33) nach Anspruch 1, gekennzeichnet durch das Zusammenwirken von mindestens einem Paar Füllstücken (40) an der besagten anderen Folie (11) mit einem Paar Oeffnungen (41) in der besagten einen Folie (10), wobei durch dieses Paar Füllstücke (40) auf dieser einen Folie (10) Chipverbindungsanschlüsse in Form von, durch die besagte dielektrische Schicht (12) von dieser einen Folie (10) isolierten Anschlussflächen (40a) vorgesehen werden, wobei die beiden Füllstücke (40) in diesem Paar Füllstücken durch das dazwischenpassende besagte eine Füllstück (42) getrennt werden, wobei diese Schicht (12) zwischen den besagten Folien (10, 11) einschliesslich besagter Füllstücke (40, 42) und besagter Oeffnungen (41, 43) eine gleichförmige dielektrische Stärke vorsieht.

3. Platte (33) nach Anspruch 1, dadurch gekennzeichnet, dass die besagten Folien (10, 11) Stromversorgungsebenen sind, wobei zur Verbindung mit den Signalleitungen einer Mehrzahl von Chips (30) eine mehrmetallige Schicht mit einem Dünnfilm-Leitungsmuster (14) auf der besagten Platte (33) abgeschieden ist.

4. Platte (33) nach Anspruch 1, gekennzeichnet durch eine Mehrzahl von mittels Lötaugen (15) direkt darauf aufmontierten Chips (30).

# FIG. 1

# FIG. 3

# FIG. 2

FIG. 4A

FIG. 4B

FIG. 4C

FIG. 5A

FIG. 5B

FIG. 5C

# FIG. 6